# EUROPÄISCHE PATENTSCHRIFT

(11) **EP 2 843 695 B1**
(45) Veröffentlichungstag und Bekanntmachung des Hinweises auf die Patenterteilung: **28.10.2020**
(21) Anmeldenummer: 13182110.0
(22) Anmeldetag: 28.08.2013
(51) Int. Cl.: H01L 21/68, H01L 21/683

(54) **Vorrichtung, insbesondere Endeffektor**
Device, in particular end effector
Dispositif, notamment effecteur terminal

(43) Veröffentlichungstag der Anmeldung: 04.03.2015
(73) Patentinhaber: Mechatronic Systemtechnik GmbH, 9500 Villach (AT)
(72) Erfinder: Glantschnig, Arno, 9065 Reichersdorf (AT); Schett, Andreas, 9920 Sillian (AT)
(74) Vertreter: Jell, Friedrich

(56) Entgegenhaltungen:
- EP-A2- 1 291 901
- WO-A1-2006/072422
- WO-A2-2008/070302
- US-A1- 2008 038 903
- US-A1- 2012 257 952

## Beschreibung

Die Erfindung betrifft eine Vorrichtung, insbesondere Endeffektor, zum Aufnehmen, Transportieren und/oder Positionieren eines Waferrahmens, der mit einer Trägerfolie zum Tragen eines Wafers bespannt ist, mit einer Halterung, die Vakuumdüsen zum berührenden Halten des Waferrahmens an der Vorrichtung aufweist, und mit einer Zentriereinrichtung, die mindestens einen in eine Aussparung des Waferrahmens eingreifbaren Anschlag zur Zentrierung des Waferrahmens aufweist.

Um einen Waferrahmen, der mit einer Trägerfolie zum Tragen eines Wafers bespannt ist, aus einer Kassette entnehmen zu können, sind Endeffektoren bzw. Greifer bekannt (DE10259836A1), die die Trägerfolie und/oder den Waferrahmen mit Vakuumdüsen am Greifer festhalten. Zur Zentrierung des entnommenen Waferrahmens ist der Greifer mit einer einen Anschlag für den Waferrahmen aufweisenden Zentriereinrichtung versehen. Der Anschlag weist hierzu mehrere, in Aussparungen des Waferrahmens eingreifende Justierstifte sowie ein am Waferrahmens flach anliegendes Anschlagelement auf. Nachteilig bedarf es bei solch einer Zentriereinrichtung einer äußerst genauen Führung des Greifers, damit Anschläge und Waferrahmen zusammenwirken können bzw. um den Waferrahmen verlässlich zu entnehmen. Zudem ist es für dieses Zusammenwirken unerlässlich, dass der Waferrahmen ausgerichtet ist. Selbst leichte Positionsabweichungen des Waferrahmens können zu dessen Verkeilen zwischen den Anschlagelementen führen und so ein sicheres Halten eines Waferrahmens verhindern. Aufgrund dadurch verursachter Ausfälle in Halbleiterfertigungs- oder Halbleiterbearbeitungsstraßen, etwa aufgrund von Reparaturen unter Reinraumbedingungen, Produktionsausfällen etc., sind derartige Greifer in diesem Technologiebereich nur bedingt geeignet.

Aus dem Stand der Technik sind auch Endeffektoren für Waferscheiben bekannt (DE10161902A1). Solche Endeffektoren sind mit Vakuumdüsen und Bernoullidüsen versehen, um damit den Wafer am Endeffektor zu halten. Zur Zentrierung des Wafers am Endeffektor ist zudem eine Zentriereinrichtung vorgesehen, die mit diametral gegenüberliegenden flachen Anschlägen den Wafer von einer Ausgangslage in eine Zentrierlage schiebt. Diese Zentrierung wird durch die konzentrische Anordnung der Bernoullidüsen unterstützt. Nachteilig bedarf es nach dem Positionieren des Wafers in die Zentrierlage einer rotatorischen Ausrichtung des Wafers, wofür der Halterung ein Drehteller zugeordnet ist. Dies führt jedoch nachteilig zu einem erheblichen konstruktiven Aufwand und ist zudem zum Zentrieren von Waferrahmen, die einen Wafer über eine Trägerfolie halten, nicht geeignet. Eine ähnliche Vorrichtung ist in der WO 2006/072422 A1 gezeigt.

Der Erfindung liegt somit die Aufgabe zugrunde, ausgehend vom eingangs geschilderten Stand der Technik, einen Endeffektor dahin gehend zu verbessern, dass der Wafer samt Waferrahmen gegenüber dem Endeffektor zuverlässig und genau zentriert wird und trotzdem keine Beeinträchtigung bei weiteren Handhabungsschritten auftritt. Darüber hinaus soll diese Vorrichtung auch eine hohe Standfestigkeit aufweisen.

Die Erfindung löst die gestellte Aufgabe dadurch, dass die Halterung Bernoullidüsen zum berührungslosen Halten und Bewegen des Waferrahmens in Richtung des Anschlags aufweist, und dass der Anschlag entgegen der von den Bernoullidüsen erzeugten Bewegungsrichtung von einer Ausgangslage in eine davon unterschiedliche Zentrierlage verstellbar gelagert ist.

Weist die Halterung Bernoullidüsen zum berührungslosen Halten und Bewegen des Waferrahmens in Richtung des Anschlags - unter anderem mithilfe eines durch den Bernoulli-Effekt verursachten hydrodynamischen Unterdrucks - auf, und ist der Anschlag entgegen der von den Bernoullidüsen erzeugten Bewegungsrichtung von einer Ausgangslage in eine davon unterschiedliche Zentrierlage verstellbar gelagert, kann ein Waferrahmen vom Greifer problemlos gegriffen und anschließend verlässlich zentriert werden. Die Bernoullidüsen sorgen hierfür nicht nur für ein berührungsloses Halten des Waferrahmens samt seiner Trägerfolie und des Wafers, sondern auch für ein verlässliches Verschieben des gehalten Waferrahmens in Richtung des Anschlags - und zwar unabhängig von der Ausgangslage des gegriffenen Waferrahmens. Die erfindungsgemäße Vorrichtung kann sich daher als äußerst tolerant gegenüber Lageabweichungen des zu greifenden Waferrahmens erweisen und damit auch ein standfestes Halten sicherstellen. Zudem ist der Waferrahmen nach einem Bewegen des Anschlags in die Zentrierposition zentriert, weil die andere Ausrichtungsachse durch den in Aussparungen eingreifende Anschlag festgelegt ist. Weiter erlaubt die bewegliche Lagerung des Anschlags, dass der Anschlag vom Waferrahmen entfernt werden kann, falls dies im Zuge eines Bearbeitungsschrittes notwendig sein sollte. Zudem können die Vakuumdüsen die feste Lagerung des Waferrahmens an der Vorrichtung übernehmen. Der Anschlag kann daher also eine Beeinträchtigung von weiteren Handhabungsschritten des Waferrahmens vermeiden.

Im Allgemeinen wird erwähnt, dass die verstellbare Lagerung des Anschlags natürlich nicht nur in die Zentrierlage, sondern auch von dieser zurück in die Ausgangslage vorgesehen ist. Mit Bernoulli-Effekt wird der bekannte Effekt zum berührungslosen Halten eines Werkstücks durch den, von einer aus einer Düse austretenden Gasströmung verursachten Unterdruck beschrieben. Um einen Bernoulli-Effekt für ein kreisförmiges Werkstück auszubilden, können ringförmig angeordnete Düsen aber auch eine Ringdüse verwendet werden. Natürlich sind auch andere Düsenanordnungen denkbar, mit denen die gewünschte Gasströmung erzeugt werden kann. Weiters soll klargestellt werden, dass im Zuge dieser Erfindung die Verwendung eines Waferrahmens auch zumindest die Trägerfolie und eventuell den damit bestückten Wafer inkludiert.

Die Standfestigkeit der Ausrichtung des Waferrahmens entlang einer Achse kann erhöht werden, wenn der Anschlag zwei parallele Zentriernasen ausbildet, die in je eine Aussparung am Waferrahmen eingreifen. Zudem kann mithilfe der Zentriernasen und der entsprechenden Aussparung des Waferrahmens eine besonders genaue Ausrichtung zwischen Anschlag und Waferrahmen erreicht werden. Ein exaktes Einnehmen der Zentrierposition des Waferrahmens an der Vorrichtung kann damit sichergestellt werden.

Weist die Zentriereinrichtung eine Linearführung zwischen Anschlag und Vorrichtung auf, kann auf besonders einfache Weise die Zentrierposition angefahren werden.

In einer vorteilhaften Ausführung der Vorrichtung weist die Zentriereinrichtung einen Druckluftantrieb zur Bewegung des Anschlags auf. Aufgrund des geringen Wartungsbedarfs eines pneumatischen Antriebs kann somit eine besonders standfeste Vorrichtung geschaffen werden.

Der konstruktive Aufwand im Bereich der Führung des Anschlags kann weiter verringert werden, wenn die Zentriereinrichtung ein mit dem Anschlag verbundenes Federelement zur Rückführung des Anschlags, also in dessen Ausgangslage, aufweist.

Sind die Bernoullidüsen asymmetrisch über die Halterung verteilt angeordnet, kann der Waferrahmen durch die entstehende Gasströmung auf konstruktiv einfache Weise berührungsfrei in Richtung des Anschlags bewegt werden. Zudem kann damit sichergestellt werden, dass die Bernoullidüsen den Waferrahmen stets auf den Anschlag zu- bzw. auflaufen lassen, auch bei Verlagerung von Ausgangs- in die Zentrierlage.

Jener Bereich des Waferrahmens, der für das Vorsehen des Wafers reserviert ist bzw. an dem der Wafer vorgesehen ist, kann gegenüber einer direkten Beaufschlagung durch die Bernoullidüsen geschützt werden, indem die Bernoullidüsen im Folienbereich zwischen Waferrahmen und Wafer an der Halterung verteilt angeordnet sind. Sind die Bernoullidüsen konzentrisch angeordnet, kann für eine gleichmäßige berührungslose Bewegung des Waferrahmens über der Halterung gesorgt werden.

Außerdem kann mit einer gleichmäßigen Haltekraft auf den Waferrahmen bzw. seine Trägerfolie eine sichere Handhabung erreicht werden.

Ein stabiler, nach außen gerichteter hydrodynamischer Unterdruck kann erzeugt werden, wenn die Bernoullidüsen schräg nach außen gerichtet sind.

Der Vortrieb des Waferrahmens in Richtung des Anschlags kann konstruktiv ermöglicht werden, indem die anschlagseitigen Bernoullidüsen parallel zur Bewegungsrichtung und die diesen gegenüberliegenden Bernoullidüsen vom inneren Zentrum ausgehend schräg nach außen gerichtet sind.

Zu Vorgenanntem alternativ oder zur Verbesserung des Vortriebs kann der Schrägwinkel α der anschlagseitigen Bernoullidüsen zum Schrägwinkel β der gegenüberliegenden Bernoullidüsen unterschiedlich groß sein.

Sind am äußeren Rand der Halterung mehrere Vakuumdüsen vorgesehen, kann der Waferrahmen sicher an der Vorrichtung gehalten werden. Zudem können damit direkt wirkende Belastungen auf die Trägerfolie bzw. den Wafer vermieden und deren Beschädigung ausgeschlossen werden - zumal nicht ausgeschlossen werden kann, dass der Wafer auf der Trägerfolie bereits zersägt vorliegt und dessen Ablösen zu befürchten ist. Wenn die Vakuumdüsen an diametral gegenüberliegenden Vorsprüngen der Halterung vorgesehen sind, kann der Waferrahmen besonders fest an der Vorrichtung gehalten werden.

Weist die Halterung einen Außenbereich und einen dazu erhöhten Innenbereich auf, die zwischen sich einen Anschlagrand für den Waferrahmen ausbilden, kann die Zentrierung des Waferrahmens zusätzlich erleichtert werden. Durch den Anschlagrand kann nämlich beim Greifen des Waferrahmens die Anzahl an möglichen Ausgangslagen beschränkt werden, insbesondere wenn ein umlaufender Anschlagrand vorgesehen ist.

Vorteilhaft können die Vakuumdüsen im Außenbereich und die Bernoullidüsen im Innenbereich vorgesehen sein, um damit das berührungslose Zentrieren des Waferrahmens sowie das feste Halten des Waferrahmens in der Zentrierlage zu erleichtern.

Der Anschlagrand kann dem Innenbereich schräg zulaufen, um die Gefahr einer Beschädigungen der Trägerfolie beim Greifen und anschließenden Zentrieren des Waferrahmens zu reduzieren.

In den Figuren ist beispielsweise der Erfindungsgegenstand anhand einer Ausführungsvariante näher dargestellt. Es zeigen
- Fig. 1: eine Draufsicht auf eine Vorrichtung zum Aufnehmen, Transportieren und/oder Positionieren eines Waferrahmens,
- Fig. 2: eine abgerissene und vergrößerte Draufsicht der Fig. 1,
- Fig. 3: eine Schnittansicht nach III-III der nach Fig 1 dargestellten Vorrichtung,
- Fig. 4: eine Draufsicht auf die Vorrichtung nach Fig. 1 mit gehaltenem Waferrahmen und
- Fig.5: eine Draufsicht auf die Vorrichtung nach Fig. 1 mit gehaltenen Waferrahmen in dessen Zentrierlage.

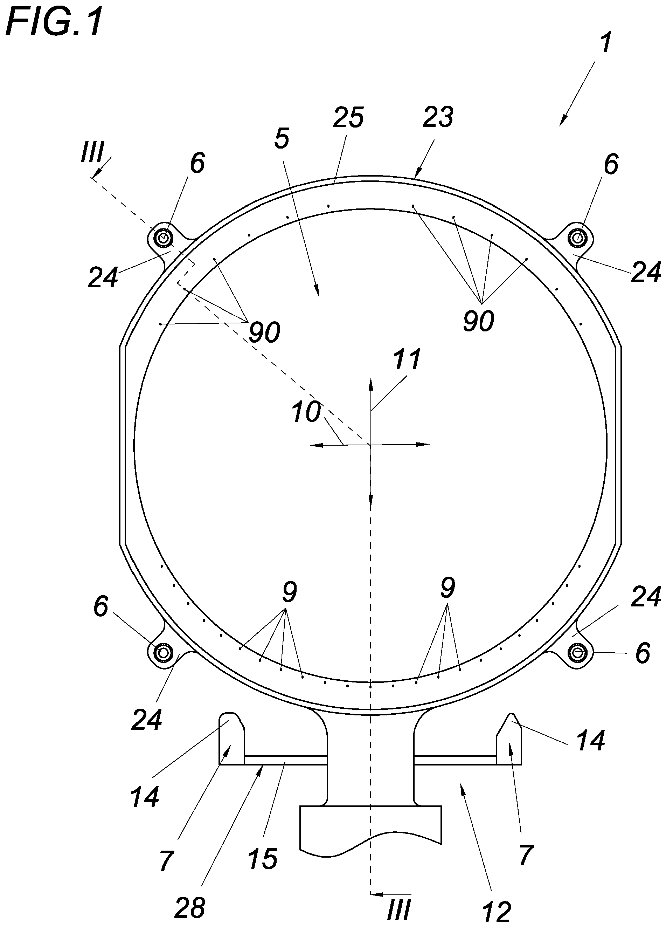

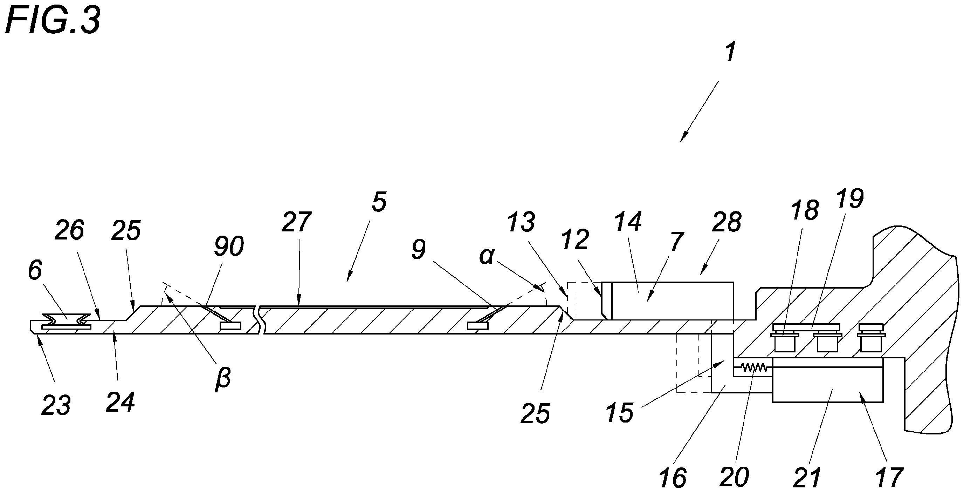

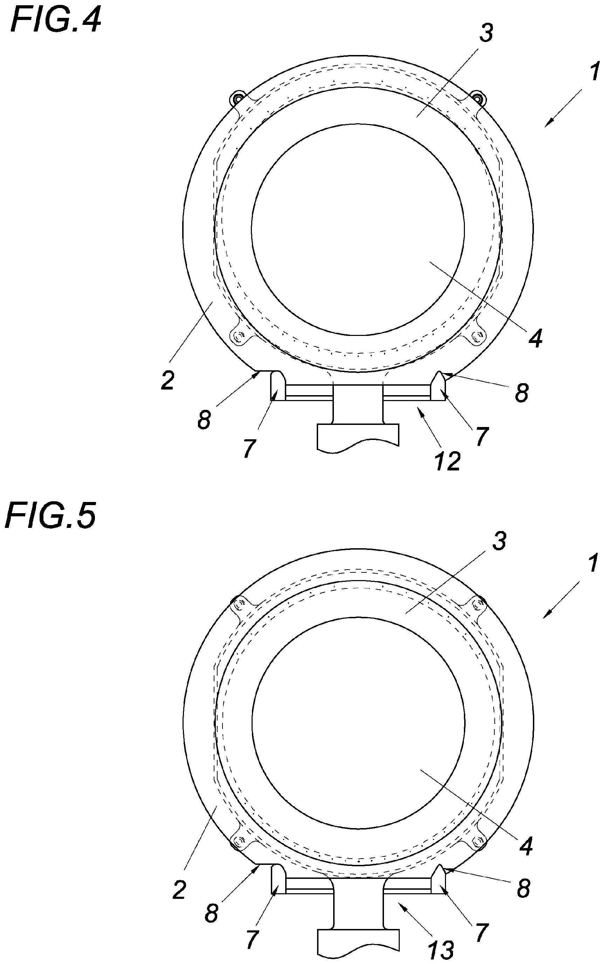

Gemäß den Figuren 1, 3 und 4 wird beispielsweise eine Draufsicht auf eine als Endeffektor bzw. Greifer ausgeführte Vorrichtung 1 zum Aufnehmen, Transportieren und/oder Positionieren eines Waferrahmens 2 gezeigt. Der Waferrahmen 2, der nach den Figuren 3 und 4 näher dargestellt ist, spannt eine Trägerfolie 3 auf, die einen Wafer 4 bzw. Halbleiterwafer stoffschlüssig trägt. Um den bespannten Waferrahmen 2 mit der Vorrichtung 1 fest zu verbinden, ist die Vorrichtung 1 mit einer Halterung 5 versehen, der Vakuumdüsen 6 zum Ansaugen des Waferrahmens 2 an die Halterung bzw. an die Vorrichtung 1 zugeordnet sind. Zudem befindet sich an der Vorrichtung 1 eine Zentriereinrichtung 28 mit einem Anschlag 7, der in zwei Aussparungen 8 am Waferrahmen 2 eingreifbar ausgebildet ist. Der Anschlag 7 dient zur Zentrierung des gehaltenen Waferrahmens 2 bzw. des Wafers 4 an der Vorrichtung 1, nachdem der Waferrahmens 2 aufgenommen worden ist - beispielsweise aus einer nicht näher dargestellten Kassette. Für eine gegenüber der Lage des Waferrahmens 2 tolerante Aufnahme der Vorrichtung 1 ist die Halterung mit Bernoullidüsen 9, 90 versehen, die den Waferrahmen 2 nicht nur berührungslos halten, sondern die auch derart vorgesehen und/oder ausgestaltet sind, dass der Waferrahmen 2 in Richtung des Anschlags 7 bewegt und damit stets gegen den Anschlag 7 gedrückt wird. Da der Anschlag 7 in Aussparungen 8 des Waferrahmens eingreift, ist eine Zentrierung des Waferrahmens 2 bzw. des Wafers 4 entlang der Bewegungsachse 10 erreicht. Das berührungslose Halten des Waferrahmens 2 wird durch im Stand der Technik unter Bernoulli-Effekt bekannten hydrodynamischen Unterdruck der Bernoullidüsen 9, 90 ermöglicht. Indem der Anschlag 7 entgegen der von den Bernoullidüsen 9, 90 erzeugten Bewegungsrichtung 11 von einer Ausgangslage 12 in eine davon unterschiedliche Zentrierlage 13 verstellbar gelagert ist, kann der am Anschlag 7 angedrückte Waferrahmen 2 auch in dessen Bewegungsachse 11 zentriert werden. Dieser Zentriervorgang ist in der Zusammenschau von Fig. 4 und 5 nachzuvollziehen. Der nach Fig. 5 zentrierte Waferrahmen 2 wird in weiterer Folge in dieser Zentrierlage 13 durch Aktivieren der Vakuumdüsen 6 verlässlich festgehalten. Die Bernoullidüsen 9, 90 können dann ausgeschaltet werden. Damit ist eine Vorrichtung 1 geschaffen, die bei einfachen Handhabungsverhältnissen einen Waferrahmen 2 standfest aufnehmen, transportieren und positionieren kann.

Der Waferrahmen 2 wird vom Anschlag 7 besonders sicher formschlüssig gefasst, indem dieser zwei parallele Zentriernasen 14 ausbildet. Da diese in verjüngende Aussparungen 8 am Waferrahmen 2 eingeführt werden, werden auch Ungenauigkeiten in der Ausrichtung des Waferrahmens 2 in der Bewegungsachse 10 ausgeglichen. Dies stellt sich zudem automatisch durch die dem Waferrahmen von den Bernoullidüsen 9, 90 aufgezwungene Bewegung in Bewegungsrichtung 11 und/oder 12 ein.

Die Bewegung des Anschlags 7 wird mit Hilfe einer Linearführung 15 an der Halterung 5 ermöglicht. Natürlich sind hierfür auch andere Führungen vorstellbar. Diese zwischen Halterung 5 und Anschlag 7 vorgesehene Linearführung 15 wird mit Hilfe einer Kolbenstange 16 eines Druckluftantriebs 17 realisiert. Vorteilhaft wird der Druckluftantrieb 17 über ein Ventil 18, welches mit der Gaszufuhr 19 der Bernoullidüsen 9, 90 verbunden ist, mit Druckluft versorgt. Dieser als einfachwirkender Zylinder ausgeführte Druckluftantrieb 17 wird über ein Federelement 20 in seine Ausgangslage 12 zurückgestellt. Hierzu greift das Federelement 20 an der Kolbenstange 16 und am Gehäuse 21 des Druckluftantriebs 17 an.

Wie insbesondere der Fig. 1 zu entnehmen, sind die Bernoullidüsen 9, 90 asymmetrisch über die Halterung 5 konzentrisch verteilt angeordnet, um damit stets eine Bewegungsrichtung 11 des Waferrahmens 2 in Richtung des Anschlags 7 aufrecht zu erhalten. Auf konstruktiv einfache Weise ist am, dem Anschlag 7 gegenüberliegenden Rand der Halterung 5 eine geringere Anzahl an Bernoullidüsen 90 vorgesehen, als dies bei den Bernoullidüsen 9 am Rand der Halterung 5, angrenzend an den Anschlag 7, der Fall ist.

Der Wafer wird von einer direkten Beaufschlagung der Bernoullidüsen 9, 90 geschützt, in dem diese Bernoullidüsen 9, 90 ausschließlich im Bereich der Trägerfolie 3 zwischen Waferrahmen 2 und Wafer 4 über die Halterung 5 verteilt angeordnet sind. Im Allgemeinen ist vorstellbar, weitere nicht näher dargestellte Bernoullidüsen im Bereich des Zentrums der Halterung 3 bzw. unterhalb des Wafers 4, etc. anzuordnen. Vorzugsweise befinden sich jedoch alle Bernoullidüsen 9, 90 im Bereich der Trägerfolie 3 zwischen Waferrahmen 2 und Wafer 4.

Wie der Fig. 3 zu entnehmen, sind die Bernoullidüsen 9, 90 schräg nach außen ausgerichtet. Dies ist unter anderem für eine gleichmäßige Beabstandung beim berührungslosen Halten des Waferrahmens 2 von Vorteil. Zudem sind in der Fig. 3 die Schrägwinkel α und β der anschlagseitigen Bernoullidüsen 9 und der den anschlagseitigen Bernoullidüsen 9 gegenüberliegenden Bernoullidüsen 90 zu erkennen. Diese Schrägwinkel α und β sind unterschiedlich groß, um damit bereit dem Waferrahmen 2 eine Bewegungsrichtung 11 sicher aufzuzwingen.

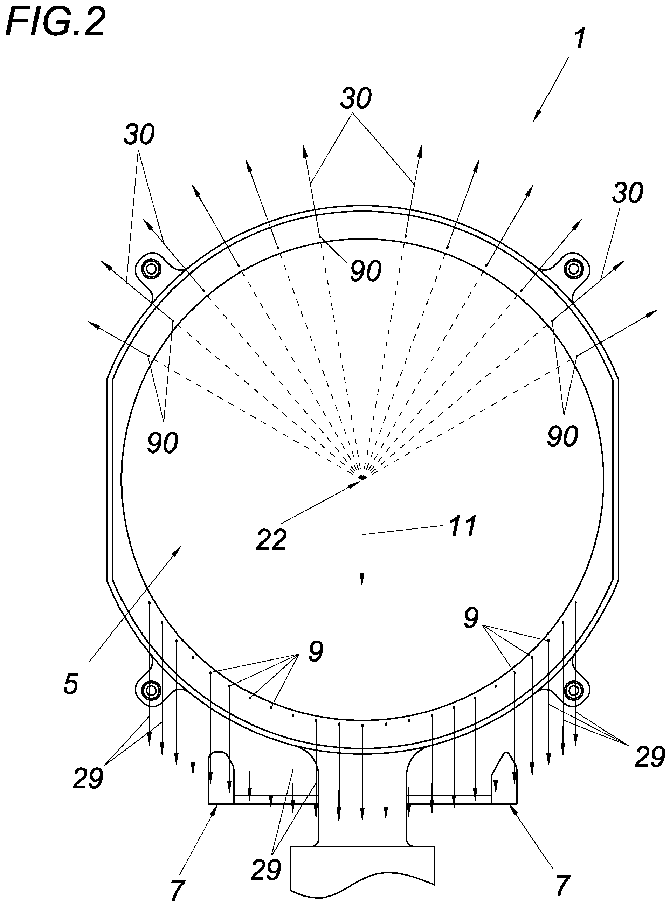

Wie in der Fig. 2 zu erkennen, sind die Bernoullidüsen 9, 90 auch in Draufsicht unterschiedlich ausgerichtet. Die anschlagseitigen Bernoullidüsen 9 weisen nämlich einen parallele Strömungsrichtung 29 und die diesen gegenüberliegenden Bernoullidüsen 90 eine sternförmig auseinanderlaufende Strömungsrichtung 30 auf. Hierzu sind die anschlagseitigen Bernoullidüsen 9 parallel zur Bewegungsrichtung 11 und die diesen gegenüberliegenden Bernoullidüsen 90 vom inneren Zentrum 22 ausgehend schräg nach außen gerichtet. Dies verbessert nochmals die Genauigkeit der Zentrierung des Waferrahmens 2, da sich aufgrund der so entwickelten Kraft gegen den Anschlag 7 ein Spiel zwischen Waferrahmen 2 und Anschlag 7 vermieden wird.

Die Vakuumdüsen 6 sind am äußeren Rand 23 der Halterung 5 vorgesehen, und zwar an diametral gegenüberliegenden Vorsprüngen 24 was eine kompakte Bauform der Vorrichtung 1 ermöglicht.

Wie zudem nach den Figuren 1, 2 und 3 näher zu erkennen, bildet die Halterung 5 einen umlaufenden Anschlagrand 25 für den Waferrahmen 2 aus. Dies wird konstruktiv durch einen Außenbereich 26 und einen dazu erhöhten Innenbereich 27 gelöst. Der berührungslos bewegte Waferrahmen 2 kann über diesen Rand nicht von der Halterung 5 abgleiten. Die Vorrichtung 1 bietet dadurch höchste Handhabungssicherheit im Aufnehmen, Transportieren und/oder Positionieren eines Waferrahmens 2 bzw. Wafers 4. Beschädigungen des Waferrahmens 2 werden mit Hilfe eines dem Innenbereich 27 schräg zulaufenden Anschlagrands 4 vermieden.

Konstruktiv einfach werden die Düsen 6, 9 durch Außenbereich 26 und einen dazu erhöhten Innenbereich 27 voneinander getrennt, indem die Vakuumdüsen 6 im Außenbereich 26 und die Bernoullidüsen 9, 90 im Innenbereich 27 vorgesehen sind.

An beispielhaft durchgeführten Arbeitsschritten soll eine erfindungsgemäße Ausführung des Waferrahmen-Endeffektors bzw. der Vorrichtung 1 näher erläutert. Zum Aufnehmen des Waferrahmens 2 erfolgt ein kurzes Ansaugen mit den Vakuumdüsen 6, sodass der Innenbereich der Halterung 5 nahe genug an die Trägerfolie 3 heranreicht. Nachfolgen werden die Bernoullidüsen 9, 90 im Innenbereich 27 der Halterung 5 aktiviert, um einen Unterdruck entsprechend dem Bernoulli-Effekt auszubilden. Nun hängt der Waferrahmen 2 berührungslos an der Vorrichtung 1 und kann sich selbst lateral ausrichten, wenn der Waferrahmen 2 bzw. Frame, zum Beispiel in eine Transportbox, eingeführt oder aus dieser entnommen wird.

Die erfindungsgemäße Zentrierung des Waferrahmens 2 erfolgt in einem nachfolgenden Schritt. Dabei strebt der Waferrahmen 2 dem Anschlag 7 der Vorrichtung 1 aufgrund der asymmetrischen Gasströmung, die von den asymmetrisch angeordneten Bernoullidüsen 9, 90 bewirkt wird, entgegen (vgl. Fig. 4). Durch die im Anschlag 7 ausgeprägten Zentriernasen 14 und die zugehörigen Aussparungen 8 im Waferrahmen 2 erfolgt die Zentrierung des Waferrahmens in Richtung der Längsachse der Vorrichtung 1. Der Waferrahmen 2 befindet sich nun in seiner Ausgangslage 12 des Zentriervorgangs - wie dies in Fig. 4 zu erkennen ist. Erfindungsgemäß wird nun der Anschlag 5 entlang der linearen Führungsbahn quer zur Längsachse in die definierte Zentrierposition 13 positioniert. Dies erfolgt entgegen der von den asymmetrischen Bernoullidüsen 9, 90 vorgegebenen Bewegungsrichtung 11. Ist die Zentrierposition 13 erreicht, werden die Vakuumdüsen 6 aktiviert, um den Waferrahmen 2 in der definierten Zentrierposition auf der Vorrichtung 1 fest zu halten. Erfindungsgemäß kann nun der Anschlag 7 in seine Ausgangslage 12 zurückgeführt und die Bernoullidüsen 9, 90 abgeschaltet werden, um weitere Arbeitsschritte auf einfache Weise möglich zu machen.

## Patentansprüche

1. Vorrichtung, insbesondere Endeffektor, zum Aufnehmen, Transportieren und/oder Positionieren eines Waferrahmens (2), der mit einer Trägerfolie (3) zum Tragen eines Wafers (4) bespannt ist, mit einer Halterung (5), die Vakuumdüsen (6) zum berührenden Halten des Waferrahmens (2) an der Vorrichtung aufweist, und mit einer Zentriereinrichtung (28), die mindestens einen in eine Aussparung (8) des Waferrahmens (2) eingreifbaren Anschlag (7) zur Zentrierung des Waferrahmens (2) aufweist, **dadurch gekennzeichnet, dass** die Halterung (5) Bernoullidüsen (9, 90) zum berührungslosen Halten und Bewegen des Waferrahmens (2) in Richtung des Anschlags (7) aufweist, und dass der Anschlag (7) entgegen der von den Bernoullidüsen (9, 90) erzeugten Bewegungsrichtung (11) von einer Ausgangslage (12) in eine davon unterschiedliche Zentrierlage (13) verstellbar gelagert und damit zum Zentrieren des Waferrahmens (2) ausgebildet ist.

2. Vorrichtung nach Anspruch 1, **dadurch gekennzeichnet, dass** der Anschlag (7) zwei parallele Zentriernasen (14) ausbildet, die in je eine Aussparung (8) am Waferrahmen eingreifen.

3. Vorrichtung nach Anspruch 1 oder 2, **dadurch gekennzeichnet, dass** die Zentriereinrichtung (28) eine Linearführung (15) zwischen Anschlag (7) und Vorrichtung (1) aufweist.

4. Vorrichtung nach Anspruch 1, 2 oder 3, **dadurch gekennzeichnet, dass** die Zentriereinrichtung (28) einen Druckluftantrieb (17) zur Bewegung des Anschlags (7) aufweist.

5. Vorrichtung nach einem der Ansprüche 1 bis 4, **dadurch gekennzeichnet, dass** die Zentriereinrichtung (28) ein mit dem Anschlag (7) verbundenes Federelement (20) zur Rückführung des Anschlags (7) aufweist.

6. Vorrichtung nach einem der Ansprüche 1 bis 5, **dadurch gekennzeichnet, dass** Bernoullidüsen (9, 90) asymmetrisch über die Halterung (5) verteilt angeordnet sind.

7. Vorrichtung nach einem der Ansprüche 1 bis 6, **dadurch gekennzeichnet, dass** die Bernoullidüsen (9, 90) im Folienbereich zwischen Waferrahmen (2) und Wafer (4) an der Halterung (5) verteilt, insbesondere konzentrisch, angeordnet sind.

8. Vorrichtung nach einem der Ansprüche 1 bis 7, **dadurch gekennzeichnet, dass** die Bernoullidüsen (9, 90) schräg nach außen gerichtet sind.

9. Vorrichtung nach Anspruch 8, **dadurch gekennzeichnet, dass** die anschlagseitigen Bernoullidüsen (9) parallel zur Bewegungsrichtung (11) und die diesen gegenüberliegenden Bernoullidüsen (90) vom inneren Zentrum ausgehend schräg nach außen gerichtet sind.

10. Vorrichtung nach Anspruch 8 oder 9, **dadurch gekennzeichnet, dass** der Schrägwinkel (a) der anschlagseitigen Bernoullidüsen (9) zum Schrägwinkel (β) der gegenüberliegenden Bernoullidüsen (90) unterschiedlich groß ist.

11. Vorrichtung nach einem der Ansprüche 1 bis 10, **dadurch gekennzeichnet, dass** am äußeren Rand (23) der Halterung (5), insbesondere an diametral gegenüberliegenden Vorsprüngen (24) der Halterung (5), Vakuumdüsen (6) vorgesehen sind.

12. Vorrichtung nach einem der Ansprüche 1 bis 11, **dadurch gekennzeichnet, dass** die Halterung (5) einen Außenbereich (26) und einen dazu erhöhten Innenbereich (27) aufweist, die zwischen sich einen, insbesondere umlaufenden, Anschlagrand (25) für den Waferrahmen (2) ausbilden.

13. Vorrichtung nach einem der Ansprüche 12, **dadurch gekennzeichnet, dass** die Vakuumdüsen (6) im Außenbereich (26) und die Bernoullidüsen (9, 90) im Innenbereich (27) vorgesehen sind.

14. Vorrichtung nach einem der Ansprüche 12 oder 13, **dadurch gekennzeichnet, dass** der Anschlagrand (25) dem Innenbereich (27) schräg zuläuft.

## Claims

1. Apparatus, particularly end effector, for taking up, transporting and/or positioning of a wafer frame (2), which is covered by a carrier film (3) for carrying a wafer (4), having a holder (5) that has vacuum nozzles (6) for contacting holding the wafer frame (2) on the apparatus, and having a centering device (28) that has at least one stop (7) that can engage into a recess (8) of the wafer frame (2), for centering of the wafer frame (2), **characterized in that** the holder (5) has Bernoulli nozzles (9, 90) for contact-free holding and moving of the wafer frame (2) in the direction of the stop (7), and that the stop (7) is adjustably mounted counter to the movement direction (11) produced by the Bernoulli nozzles (9, 90), from a starting position (12) into a centering position (13) fthat is different from the former and therefore is formed for centering of the wafer frame (2).

2. Apparatus according to claim 1, **characterized in that** the stop (7) forms two parallel centering projections (14), which each engage into a recess (8) on the wafer frame.

3. Apparatus according to claim 1 or 2, **characterized in that** the centering device (28) has a linear guide (15) between stop (7) and apparatus (1).

4. Apparatus according to claim 1, 2 or 3, **characterized in that** the centering device (28) has a compressed air drive (17) for movement of the stop (7).

5. Apparatus according to one of claims 1 to 4, **characterized in that** the centering device (28) has a spring element (20) connected with the stop (7), for return of the stop (7).

6. Apparatus according to one of claims 1 to 5, **characterized in that** Bernoulli nozzles (9, 90) are disposed so as to be asymmetrically distributed over the holder (5).

7. Apparatus according to one of claims 1 to 6, **characterized in that** the Bernoulli nozzles (9, 90) are disposed on the holder (5), distributed in the film region between wafer frame (2) and wafer (4), particularly concentrically.

8. Apparatus according to one of claims 1 to 7, **characterized in that** the Bernoulli nozzles (9, 90) are directed outward at a slant.

9. Apparatus according to claim 8, **characterized in that** the stop-side Bernoulli nozzles (9) are directed parallel to the movement direction (11), and the Bernoulli nozzles (90) that lie opposite them are directed outward at a slant, proceeding from the inner center.

10. Apparatus according to claim 8 or 9, **characterized in that** the slant angle (a) of the stop-side Bernoulli nozzles (9) is different in size from the slant angle (β) of the opposite Bernoulli nozzles (90).

11. Apparatus according to one of claims 1 to 10, **characterized in that** vacuum nozzles (6) are provided on the outer edge (23) of the holder (5), particularly at diametrically opposite projections (24) of the holder (5).

12. Apparatus according to one of claims 1 to 11, **characterized in that** the holder (5) has an outer region (26) and an inner region (27) that is elevated relative to the former, which regions form a stop edge (25), particularly a circumferential edge for the wafer frame (2) between them.

13. Apparatus according to one of claims 12, **characterized in that** the vacuum nozzles (6) are provided in the outer region (26) and the Bernoulli nozzles (9, 90) are provided in the inner region (27).

14. Apparatus according to one of claims 12 or 13, **characterized in that** the stop edge (25) runs at a slant toward the inner region (27).

## Revendications

1. Dispositif, en particulier effecteur terminal, pour recevoir, transporter et/ou positionner un cadre de plaquette (2) sur lequel est tendu un film de support (3) destiné à porter une plaquette (4), avec une fixation (5) comportant des buses à vide (6) pour le maintien avec contact du cadre de plaquette (2) sur le dispositif, et avec une installation de centrage (28) comprenant au moins une butée (7) qui peut se mettre en prise dans une découpe (8) du cadre de plaquette (2) pour le centrage du cadre de plaquette (2), **caractérisé en ce que** la fixation (5) comporte des buses de Bernoulli (9, 90) pour le maintien sans contact du cadre de plaquette (2) et son déplacement en direction de la butée (7) et **en ce que** la butée (7) est supportée avec possibilité de déplacement en sens inverse du sens de déplacement (11) produit par les buses de Bernoulli (9, 90) d'une position de départ (12) à une position de centrage (13) différente de celle-ci et conçue ainsi pour le centrage du cadre de plaquette (2).

2. Dispositif selon la revendication 1, **caractérisé en ce que** la butée (7) forme deux ergots de centrage (14) parallèles qui se mettent en prise chacun dans une découpe (8) du cadre de plaquette.

3. Dispositif selon la revendication 1 ou 2, **caractérisé en ce que** l'installation de centrage (28) présente un guidage linéaire (15) entre la butée (7) et le dispositif (1).

4. Dispositif selon la revendication 1, 2 ou 3, **caractérisé en ce que** l'installation de centrage (28) comporte un entraînement pneumatique (17) pour le déplacement de la butée (7).

5. Dispositif selon l'une des revendications 1 à 4, **caractérisé en ce que** l'installation de centrage (28) présente un élément de ressort (20) relié à la butée (7) pour rappeler la butée (7).

6. Dispositif selon l'une des revendications 1 à 5, **caractérisé en ce que** des buses de Bernoulli (9, 90) sont réparties de façon asymétrique au-dessus de la fixation (5).

7. Dispositif selon l'une des revendications 1 à 6, **caractérisé en ce que** les buses de Bernoulli (9, 90) sont réparties sur la fixation (5) au niveau du film entre le cadre de plaquette (2) et la plaquette (4), en particulier de façon concentrique.

8. Dispositif selon l'une des revendications 1 à 7, **caractérisé en ce que** les buses de Bernoulli (9, 90) sont orientées à l'oblique vers l'extérieur.

9. Dispositif selon la revendication 8, **caractérisé en ce que** les buses de Bernoulli (9) du côté de la butée sont orientées parallèlement au sens de déplacement (11) et les buses de Bernoulli (90) leur faisant face sont orientées à l'oblique vers l'extérieur à partir du centre intérieur.

10. Dispositif selon la revendication 8 ou 9, **caractérisé en ce que** l'angle d'obliquité (a) des buses de Bernoulli (9) du côté de la butée est différent de l'angle d'obliquité (β) des buses de Bernoulli (90) qui leur font face.

11. Dispositif selon l'une des revendications 1 à 10, **caractérisé en ce que** des buses à vide (6) sont prévues sur le bord extérieur (23) de la fixation (5), en particulier sur des saillies (24) diamétralement opposées de la fixation (5).

12. Dispositif selon l'une des revendications 1 à 11, **caractérisé en ce que** la fixation (5) présente une zone extérieure (26) et une zone intérieure (27) surélevée par rapport à celle-ci, qui forment entre elles un bord de butée (25), en particulier circonférentiel, pour le cadre de plaquette (2).

13. Dispositif selon la revendication 12, **caractérisé en ce que** les buses à vide (6) sont prévues dans la zone extérieure (26) et les buses de Bernoulli (9, 90) dans la zone intérieure (27).

14. Dispositif selon l'une des revendications 12 ou 13, **caractérisé en ce que** le bord de butée (25) est oblique en direction de la zone intérieure (27).
